Europäisches Patentamt

European Patent Office

Office européen des brevets

(11) Publication number: **0 046 024**
**B1**

(12) **EUROPEAN PATENT SPECIFICATION**

(45) Date of publication of patent specification: **21.11.84**

(21) Application number: **81303389.1**

(22) Date of filing: **23.07.81**

(51) Int. Cl.³: **H 02 H 3/32, G 01 R 27/18 //**
**G01R21/00**

(54) **Earth leakage current breaker.**

(30) Priority: **11.08.80 GB 8026103**

(43) Date of publication of application:
**17.02.82 Bulletin 82/07**

(45) Publication of the grant of the patent:
**21.11.84 Bulletin 84/47**

(84) Designated Contracting States:
**BE CH DE FR IT LI**

(56) References cited:
**GB-A-2 008 345**
**GB-A-2 037 104**
**US-A-4 001 646**
**US-A-4 121 269**

(73) Proprietor: **SOUTH EASTERN ELECTRICITY**
**BOARD**
**Queen's Gardens Hove**
**Sussex BN3 2LS (GB)**

(72) Inventor: **Fielden, John Spensley**
**Homeville Ottery St.Mary**
**Devon (GB)**

(74) Representative: **Rennie, Ian Malcolm et al**
**BOULT, WADE & TENNANT 27 Furnival Street**
**London EC4A 1PQ (GB)**

Courier Press, Leamington Spa, England.

## Description

This invention relates to earth leakage current breakers. The usual form of earth leakage current breakers used in domestic premises is an electromechanical device which is set to trip, and thereby interrupt the current supply to a circuit, if a leakage current to earth exceeds some predetermined value. Modern practice for earth leakage circuit breakers in domestic premises is commonly to have a sensitivity of either 100 mA or 30 mA with a tripping time of about 30 ms.

It is known, for example, from US—A— 4 001 646 to provide an earth fault circuit interrupter having transformer means coupled to both line and neutral conductors of a two-wire A.C. supply to detect any current differential, the output of the transformer secondary winding being repetitively sampled; during a first sampling period, any earth fault on the line conductor is sensed by using a thyristor fired by a control circuit responsive to the difference signal, the thyristor then operating a mechanical relay to effect switching. During the next sampling interval, a negative resistance network sets up a ringing oscillation in the transformer secondary circuit and, if the neutral conductor is earthed through a fault, the oscillation is damped and circuit interruption is initiated.

Prior art devices of this nature are relatively slow-acting and, as stated above, present-day earth leakage circuit breakers have a tripping time of about 30 ms.

It is an object of the present invention to provide an improved form of earth leakage current breaker which enables high sensitivity to be obtained with a high speed of operation and which avoids the necessity of having a mechanical device.

According to this invention, an earth leakage current breaker for an alternating electrical power supply having live and neutral lines and comprising current transformer means coupled to the live and neutral lines of said alternating supply to provide an analogue output signal representative of the difference between the total current in the live line or lines and the current in the neutral line, pulse sampling means arranged for repetitively sampling the magnitude of said analogue output signal, and switching means controlled in response to the magnitude of the samples for interrupting the current through said line or lines is characterised in that said pulse sampling means is arranged to effect sampling at least four times in each half-cycle of the supply frequency and in that digital data processing means is provided responsive to the output of the pulse sampling means and operative to provide a control signal if the sampled magnitude exceeds a predetermined magnitude a number (n) of times in a predetermined period which is substantially a half cycle of the supply frequency, where n is an integer greater than 1, and in that said switching means is solid state switching means controlled by said control signal and arranged for interrupting the current through said supply line or lines. Typically n might be chosen as 2 so that the supply is interrupted if two samples exceed some predetermined value, e.g. 20 m.amps, in a period of substantially one half cycle of the mains frequency. Thus a single current pulse in this period, such as might occur because of a switching transient or the like, would not operate the switching means but two samples, whether successive or not, in one half cycle of the supply frequency, that is 10 milliseconds would effect the required switching.

A leakage current can only be detected when the balance current, represented by the aforesaid analogue output signal is sampled. Thus the sampling rate is chosen to ensure that the current is detected quickly; typically the sampling rate might be of the order of eight samples per cycle of the supply. The supply rate need not be synchronised with the supply frequency. To avoid operation on a single transient the sampling rate should be such that n samples are made in a time which is greater than, preferably at least twice, the time duration of a transient. The digital data processing system may be arranged to count sampled inputs exceeding the predetermined level and to operate the switching means as soon as the count reaches n, the counting means being reset periodically, say every half cycle. In some cases, however, instead of operating the switches when the count n is reached, to await the end of the count period, e.g. a half cycle, and then compare the accumulated count with the value n to determine if switch operation is to be effected. The time duration before resetting the counter is not critical and conveniently is made of the same order as the time required to effect a switching operation, which, with present-day solid state switching means, is of the order of 10 milliseconds, i.e. half a cycle at the supply frequency.

By this technique, it is possible to detect an earth leakage current exceeding some predetermined limit, which may readily be a very low limit, e.g. a few milliamperes, within a very short time, e.g. a fraction of a cycle at the supply frequency, the rapidity of detection being limited primarily by the requirement to discriminate against transients. The speed of detection and operation however can readily be made much faster than existing mechanical types of earth-current operated circuit breakers.

In a single phase supply, the difference between the current in the live line and the neutral line is the leakage current. This may be detected by making use of two current transformers, one on the live line and one on the neutral line and analogue means obtaining the difference of their outputs, for example using an operational amplifier. Preferably however a single current transformer is coupled to both the live and neutral lines, for example by looping both the live and neutral input around an output coil or a core of the transformer or by using a toroidal transformer encompassing both lines. In a three-phase supply, four current transformers may be employed, one on each of the live lines and one on the neutral with analogue means, e.g. an operational amplifier, for summing their outputs. Preferably however a single current transformer is coupled to all the lines for example by having the separate live lines and neutral line looped around an output coil or a core of the transformer or by using a toroidal core encompassing all the conductors.

The digital data processing means is conveniently a microprocessor. Such a microprocessor may be used in conjunction with a current transformer and a voltage transformer for other purposes, e.g. to form a kilowatt-hour meter measuring energy consumption. Thus a large part of the apparatus of the present invention may be common to a kilowatt-hour meter. The analogue output representing the balance current may be pulse sampled by the microprocessor to obtain a control signal for one or more solid state switches for interrupting the supply. These switches conveniently are triacs or thyristor pairs.

Means may be provided for adjusting the level of leakage current at which the switch is operated.

If an earth leakage fault occurs, in some cases it may be desirable that a check should be made to ascertain the cause of the fault before the supply is restored; in these circumstances no automatic reset would be provided after the supply is interrupted. Manually operable reset means may thus be provided for restoring the supply when it is safe to do so.

With the high speed of operation provided by the present invention, more generally it may be preferred to provide means for automatically re-closing the switching means to restore the supply, with a predetermined delay, after the switching means is operated on detection of the earth leakage current. The delay might typically be a few seconds, e.g. 5 or 6 seconds, and provision may be made for adjusting this delay. If an earth leakage fault is still present, the apparatus of the present invention will immediately come into operation to interrupt the supply again.

In the following description, reference will be made to the accompanying drawings in which:—

Figure 1 is a block diagram illustrating diagrammatically one form of earth leakage current breaker;

Figure 2 is a graphical diagram for explanatory purposes; and

Figures 3 and 4 are diagrams illustrating modifications of parts of the apparatus of Figure 1.

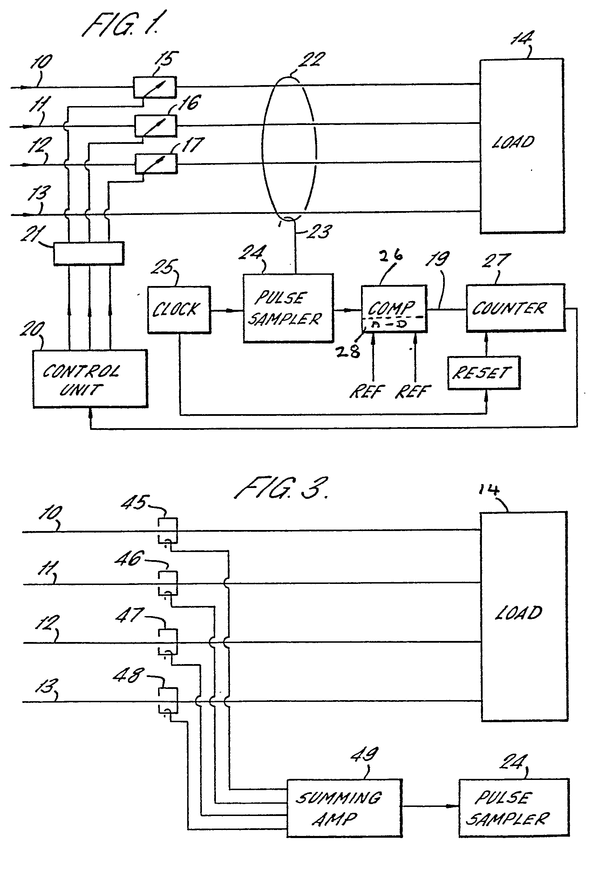

Referring to Figure 1, there is shown a three-phase supply comprising live lines 10, 11 and 12 with a neutral 13 for supplying power to a load indicated diagrammatically at 14. In the lines 10, 11 and 12 there are solid state switches 15, 16, 17 respectively, e.g. triacs, which are controlled by output signals from a control unit 20 via an optical isolator 21.

Around the lines 10 to 13 is a single current transformer 22 in the form of a toroid linked to all the supply leads and providing an output voltage on a winding 23 representative of the out-of-balance currents in the lines 10 to 13, that is to say the vector sum of the three line currents in lines 10 to 12 less the neutral current in line 13. This out-of-balance current is thus the earth leakage current.

The magnitude of this voltage on winding 23 is sampled by a pulse sampler 24 controlled by a clock 25 and, in this particular embodiment, effecting sampling regularly and repetitively at a frequency such that 8 samples are made in the time duration of 1 cycle of the supply, i.e. 20 milliseconds. The sampled magnitude is applied to a comparator 26 which gives a pulse output on lead 19 whenever the magnitude exceeds a predetermined level corresponding to the magnitude of leakage current, e.g. 10 milliamperes, which is to be detected. The comparator 26, in this embodiment is arranged to respond to voltages of either polarity provided their magnitude (either positive or negative) is above a predetermined positive value or below a predetermined negative value. The pulses on lead 19 are counted in a counter 27 which is reset periodically, e.g. after every four sampling pulses. The reset need not be synchronised with the supply but, in this particular case, the reset will be substantially every half cycle of the sample. In this particular embodiment, if the count in the counter 27 reaches two, a signal is fed from the counter 27 to the control unit 20 to operate the switches 15, 16 and 17.

In some cases, instead of operating the switches when the count reaches 2, it may be preferred to await the end of the count period and then compare the accumulated current with $n$ to determine if switch operation is required.

The comparator 26 preferably is a digital comparator, the analogue samples each being converted to digital form by an analogue-to-digital converter 28 before being compared with the reference level which, in this case, is in digital form.

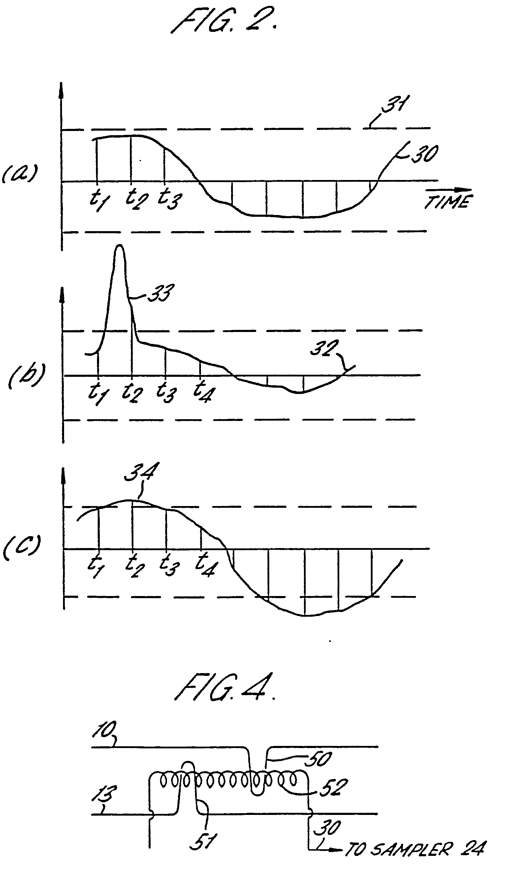

Referring to Figure 2, at (a) there is shown a current waveform 30, representing the out-of-balance current. For a three-phase supply, such a current waveform is very irregular. This waveform is sampled periodically, at time instants marked $t_1$, $t_2$, $t_3$ etc. The sampling is repetitive and, as stated above, might be at a rate of 8 samples every 20 milliseconds. Provided, as in (a), at all the sampling points the magnitude is below the predetermined level indicated by the dashed line 31, representing the leakage current level at which switching is required, the counter will not record any count. If, as shown at (b), the waveform 32 has a short duration transient 33 of large magnitude, this will be detected by the comparator but, because of the short duration, only a single count will be recorded before the counter is reset. If an earth leakage fault occurs, then as shown at (c), the amplitude of waveform 34 exceeds the limits at more than two sampling points before the counter is reset, then the switching means is operated to switch off the supply.

Instead of a single current transformer 22, it is possible, as shown in Figure 3, to provide on the lines 10 to 12, between the switches 15 to 17 and the load, separate current transformers 45, 46 and 47 and to provide on line 13 a current transformer 48. These current transformers are all connected to an operational amplifier 49 forming a summing amplifier summing the analogue outputs of the current transformers in such a manner as to give the difference between the vector sum of the currents through the three live lines 10, 11, 12 and the current through the neutral line 13. This current difference is an analogue output signal representative of the earth leakage current in the load circuit beyond the current transformers. The output signal is an analogue waveform which is sampled as described with reference to Figure 1.

For many loads, a single-phase current only is used and in this case the difference between the live line current and the neutral current will always represent the earth leakage current if there is an earth fault. This may be detected using a current balance transformer as described with reference to Figure 1 or by analogue summing of the outputs of two current transformers.

With a three-phase or a single-phase supply, instead of having a single toroidal core or coil around all the supply leads, it is alternatively possible to couple these leads inductively to an output winding, e.g. by looping the supply leads around this winding or around a core carrying this winding. Such an arrangement is illustrated in Figure 4 for a single-phase supply, the live and neutral lines are arranged as loops 50, 51 around a coil 52 feeding the pulse sampler 24.

The comparator, pulse sampler, counter and logic control of the switches may conveniently be effected in a microprocessor. This is particularly convenient where a microprocessor is utilised also for other purposes, e.g. for metering energy consumption.

## Claims

1. An earth leakage current breaker for an alternating electrical power supply having live and neutral lines (10—13), said earth leakage current breaker comprising current transformer means (22 or 45—48 or 50—52) coupled to the live and neutral lines (10—13) of said alternating supply and arranged to provide an analogue output signal representative of the difference between the total current in the live lines or lines and the current in the neutral line, pulse sampling means (24) arranged for repetitively sampling the magnitude of said analogue output signal, and switching means (15—17) controlled in response to the magnitude of the samples for interrupting the current through said line or lines characterised in that said pulse sampling means (24) is arranged to effect the sampling at least four times in each half cycle of the supply frequency, and in that digital data processing means (26, 27) is provided responsive to the output of the sampling means (24) and operative to provide a control signal if the sampled magnitude exceeds a predetermined magnitude a number (n) of times in a predetermined period which is substantially a half cycle of the supply frequency, where n is an integer greater than 1, and in that said switching means is solid state switching means (15—17) controlled by said control signal and arranged for interrupting the current through said supply line or lines (10—13).

2. An earth leakage current breaker as claimed in claim 1 and arranged for use on a single-phase supply, characterised in that said current transformer means comprises two current transformers (50, 51), one on the live line and the other on the neutral line and analogue means for obtaining the difference of their outputs.

3. An earth leakage current breaker as claimed in claim 1 and arranged for use on a single-phase supply characterised in that said current transformer means comprises a single current transformer (22) coupled to both the live and neutral lines.

4. An earth leakage current breaker as claimed in claim 3 characterised in that said current transformer has the live and neutral lines looped around an output coil (52) or a core of the transformer.

5. An earth leakage current breaker as claimed in claim 4 characterised in that said current transformer is a toroidal transformer encompassing both lines.

6. An earth leakage current breaker as claimed in claim 1 and arranged for use on a three-phase supply characterised in that said current transformer means comprises four current transformers (45—48), one on each of the live lines and one on the neutral line with analogue means (49) for summing their outputs.

7. An earth leakage current breaker as claimed in either claim 2 or claim 6 characterised in that said analogue means comprises an operational amplifier (49).

## Patentansprüche

1. Erdschlußstromunterbrecher für ein elektrisches Wechselstromnetz mit stromführenden und neutralen Leitungen (10—13), wobei der Erdschlußstromunterbrecher Stromtransformatoreinrichtungen (22) oder (45—48) oder

(50—52), die mit den stromführenden und neutralen Leitungen (10—13) des Wechselstromnetzes gekoppelt und so angeordnet sind, daß sie ein analoges Ausgangssignal liefern, das den Unterschied zwischen dem Gesamtstrom auf der stromführenden Leitung oder den stromführenden Leitungen und dem Strom auf der neutralen Leitung wiedergibt Impulsabfrageeinrichtungen (24), die so ausgebildet sind, daß sie wiederholt die Amplitude des genannten analogen Ausgangssignals abfragen, und Schalteinrichtungen (15—17) umfaßt, die auf die Höhe der Abfragewerte ansprechend gesteuert wird, um den Strom über die genannte Leitung oder die genannten Leitungen zu unterbrechen, dadurch gekennzeichnet, daß die Impulsabfrageeinrichtungen (24) so ausgebildet sind, daß sie das Abfragen wenigstens viermal in jeder Halbperiode der Netzfrequenz bewirken, und daß digitale Datenverarbeitungseinrichtungen (26, 27) vorgesehen sind, die auf das Ausgangssignal der Abfrageeinrichtungen (24) ansprechen und so arbeiten, daß sie ein Steuersignal liefern, wenn die abgefragte Höhe eine vorbestimmte Höhe n-mal in einem vorbestimmten Zeitintervall überschreitet, das im wesentlichen gleich der Halbperiode der Netzfrequenz ist, wobei n eine ganze Zahl größer als 1 ist, und daß die Schalteinrichtungen Festkörperschalteinrichtungen (15—17) sind, die durch das genannte Steuersignal gesteuert werden und so angeordnet sind, daß sie den Strom über die Versorgungsleitung oder die Versorgunsleitungen (10—13) unterbrechen.

2. Erdschlußstromunterbrecher nach Anspruch 1 zur Verwendung bei einem Einphasennetz, dadurch gekennzeichnet, daß die Stromtransformatoreinrichtungen zwei Stromtransformatoren (50, 51) und zwar jeweils einer auf der stromführenden Leitung und der andere auf der neutralen Leitung, und Analogeinrichtungen umfaßt, um den Unterschied zwischen deren Abgabe zu erhalten.

3. Erdschlußstromunterbrecher nach Anspruch 1 zur Verwendung bei einem Einphasennetz dadurch gekennzeichnet, daß die Stromtransformatoreinrichtungen einen einzigen Stromtransformator (22) umfassen, der sowohl mit der stromführenden als auch mit der neutralen Leitung gekoppelt ist.

4. Erdschlußstromunterbrecher nach Anspruch 3, dadurch gekennzeichnet, daß bei dem Stromtransformator die stromführende Leitung und die neutrale Leitung schleifenförmig um eine Ausgangsspule (52) oder einen Kern des Transformators geführt ist.

5. Erdschlußstromunterbrecher nach Anspruch 4, dadurch gekennzeichnet, daß der Stromtransformator ein Ringkerntransformator ist, der beide Leitungen umschließt.

6. Erdschlußstromunterbrecher nach Anspruch 1 zur Verwendung bei einem Dreiphasennetz dadurch gekennzeichnet, daß die Stromtransformatoreinrichtungen vier Stromtransformatoren (45—48), und zwar jeweils einen auf jeder stromführenden Leitung und einen auf der neutralen Leitung mit einer Analogeinrichtung (49) zum Addieren ihrer Abgabe umfassen.

7. Erdschlußstromunterbrecher entweder nach Anspruch 2 oder nach Anspruch 6, dadurch gekennzeichnet, daß die Analogeinrichtung einen Operationsverstärker (49) umfaßt.

**Revendications**

1. Interrupteur de courant en cas de fuites à la terre pour une alimentation de courant alternatif ayant des lignes sous tension et neutre (10—13), ledit interrupteur de courant en cas de fuites à la terre comprenant un moyen transformateur de courant (22 ou 45—48 ou 50—52) relié aux lignes sous tension et neutre (10—13) de l'alimentation de courant alternatif et agencé pour fournir un signal de sortie analogique représentatif de la différence entre le courant total dans la ou les lignes sous tension et le courant dans le neutre, un moyen d'échantillonnage d'impulsions (24) agencé pour échantillonner de façon répétitive la grandeur du signal de sortie analogique et un moyen de commutation (15—17) commandé en réaction à la grandeur des échantillons pour interrompre le courant à travers la ou les lignes, caractérisé en ce que le moyen d'échantillonnage d'impulsions (24) est agencé pour effectuer l'échantillonnage au moins quatre fois dans chaque demi-cycle de la fréquence d'alimentation, en ce qu'on prévoit un moyen de traitement de donnés numériques (26, 27) réagissant à la sortie du moyen d'échantillonnage (24) et agissant pour fournir un signal de commande si la grandeur échantillonnée dépasse une grandeur prédéterminée d'un nombre (n) de fois dans une période prédéterminée qui est sensiblement un demi-cycle de la fréquence d'alimentation, n étant un entier supérieur à 1 et en ce que ledit moyen de commutation est un moyen de commutation à l'état solide (15—17) commandé par le signal de commande et agencé pour interrompre le courant à travers la ou les lignes sous tension (10—13).

2. Interrupteur de courant en cas de fuite à la terre selon la revendication 1, agencé pour être utilisé avec une alimentation mono-phasée, caractérisé en ce que le moyen transformateur de courant comprend deux transformateurs (50, 51) un sur la ligne sous tension et l'autre sur le neutre et un moyen analogique pour obtenir la différence de leur sorties.

3. Interrupteur de courant en cas de fuites à la terre selon la revendication 1, agencé pour être utilisé avec une alimentation mono-phasée, caractérisé en ce que le moyen transformateur de courant comprend un transformateur de courant unique (22) relié tant à la ligne sous tension qu'au neutre.

4. Interrupteur de courant en cas de fuites à la terre selon la revendication 3, caractérisé en ce que le transformateur de courant a les lignes sous tension et neutre bouclées autour d'un enroulement de sortie (52) ou d'un noyau du transformateur.

5. Interrupteur de courant en cas de fuites à la terre selon la revendication 4, caractérisé en ce que le transformateur de courant est un transformateur toroïdal entourant les deux lignes.

6. Interrupteur de courant en cas de fuites à la terre selon la revendication 1 agencé pour être utilisé avec une alimentation tri-phasée, caractérisé en ce que le moyen transformateur de courant comprend quatre transformateurs de courant (45—48), un sur chacune des lignes sous tension et un sur le neutre avec des moyens analogiques (49) pour additionner leurs sorties.

7. Interrupteur de courant en cas de fuites à la terre selon l'une des revendications 2 ou 6, caractérisé en ce que le moyen analogique comprend un amplificateur opérationnel (59).

FIG. 1.

FIG. 3.

FIG. 2.

(a)

31

30

$t_1$ $t_2$ $t_3$ TIME

(b)

33

32

$t_1$ $t_2$ $t_3$ $t_4$

(c)

34

$t_1$ $t_2$ $t_3$ $t_4$

FIG. 4.

10

50

52

13

51

30

TO SAMPLER 24

2